# FASCICULE DE BREVET EUROPEEN

(11) **EP 2 405 385 B1**
(45) Date de publication et mention de la délivrance du brevet: **10.12.2014**
(21) Numéro de dépôt: 11172651.9
(22) Date de dépôt: 05.07.2011
(51) Int. Cl.: G06K 19/073, G06K 19/077, H01L 23/58, H01L 23/00

(54) **Dispositif connectable portable à microcircuit(s) avec contre-mesure integrée contre les attaques en faute ou EMA**
Tragbare, anschließbare Vorrichtung mit Mikroschaltkreis(en) mit integrierten Gegenmaßnahmen gegen Fault- oder EMA-Angriffe
Portable connectable device with microcircuit(s), with integrated countermeasure against EMA or fault attacks

(30) Priorité: 09.07.2010 FR 1002896
(43) Date de publication de la demande: 11.01.2012
(73) Titulaire: Oberthur Technologies, 92300 Levallois-Perret (FR)
(72) Inventeur: Giraud, Christophe, 33600 PESSAC (FR); Morin, Nicolas, 33170 GRADIGNAN (FR); Thiebeauld de la Crouee, Hugues, 33600 PESSAC (FR)
(74) Mandataire: Esselin, Sophie

(56) Documents cités:
- FR-A1- 2 857 483
- US-A1- 2007 034 999

## Description

### DOMAINE DE L'INVENTION

Le domaine de l'invention est la protection des dispositifs connectables portables à microcircuit(s), contre des attaques particulières, attaques en faute par rayonnement lumineux, ou attaques passives par analyse électromagnétique dites EMA (pour *Electro-Magnetic Analysis*). L'invention concerne plus particulièrement la protection des dispositifs connectables comportant un support à microcircuit(s) encapsulé dans un corps en matière plastique, le support comprenant au moins un microcircuit fixé sur le support et connecté par des fils soudés à des plages de contact pour la connexion externe formées sur le support. Les cartes à contact(s) et/ou sans contact de tous formats, les cartes mémoire sécurisées amovibles de stockage de données comme les cartes SD *"Secure Digital"* ou ses dérivées (microSD, miniSD, SDHC....) et les clefs USB sont des exemples de tels dispositifs.

### ARRIERE-PLAN TECHNOLOGIQUE

Les attaques en faute consistent à perturber l'environnement physique du dispositif lors de son fonctionnement, pour éviter le contrôle par code PIN ou outrepasser les vérifications des mécanismes de protection logicielle déployés sur la puce. Ces attaques peuvent être réalisées lors de l'exécution du code et notamment par l'émission d'un rayonnement lumineux sur la face active d'une puce (microcircuit) du dispositif, dans le but de provoquer des erreurs sur les données utiles (mémoires, pointeur de code, registres, etc.). Par exemple, en concentrant une lumière avec une longueur d'onde spécifique sur une zone précise sur la face active de la puce, il est possible d'inverser le contenu d'un bit d'un code sur lequel repose la sécurité du dispositif.

Ces attaques requièrent donc au préalable de découvrir au moins en partie le(s) microcircuit(s) qui sont encapsulés, pour atteindre leur zone active. Plus précisément, il s'agit d'enlever toute matière non transparente au rayonnement utilisé, qui s'interpose entre la source de rayonnement lumineux ou électromagnétique et la puce.

La zone à découvrir peut-être très petite. En effet, on dispose de sources de rayonnement lasers puissantes délivrant un faisceau très fin capable de n'impacter qu'une très petite zone. Il est aussi possible de concentrer la lumière sur une très petite zone, tout en protégeant de la lumière le reste de la surface qui a été dégagée. De telles attaques très ciblées sont difficiles à détecter.

Ces attaques en faute par rayonnement optique posent un problème de sécurité et d'intégrité de ces dispositifs portables d'autant plus important qu'elles peuvent être réalisées avec peu de moyens matériels, et des moyens peu coûteux.

Les attaques par analyse EMA soulèvent la même problématique d'accès à la zone active des puces de microcircuit, puisqu'il s'agit d'approcher une sonde de mesure d'émission électromagnétique au plus près de la surface de la puce, pour espionner le champ électromagnétique proche sur une zone active, dans le but d'analyser les flux de courant localement dans le dispositif, et découvrir des informations secrètes par analyse statistique.

Pour dégager une portion de face active de microcircuit, les attaquants doivent percer au moins partiellement le corps plastique dans lequel est encapsulé le microcircuit, et dégager la résine d'encapsulation du microcircuit qui recouvre le microcircuit et les liaisons électriques, et ceci sans abîmer ces liaisons électriques. En effet, ces attaques supposent que le dispositif est parfaitement opérationnel.

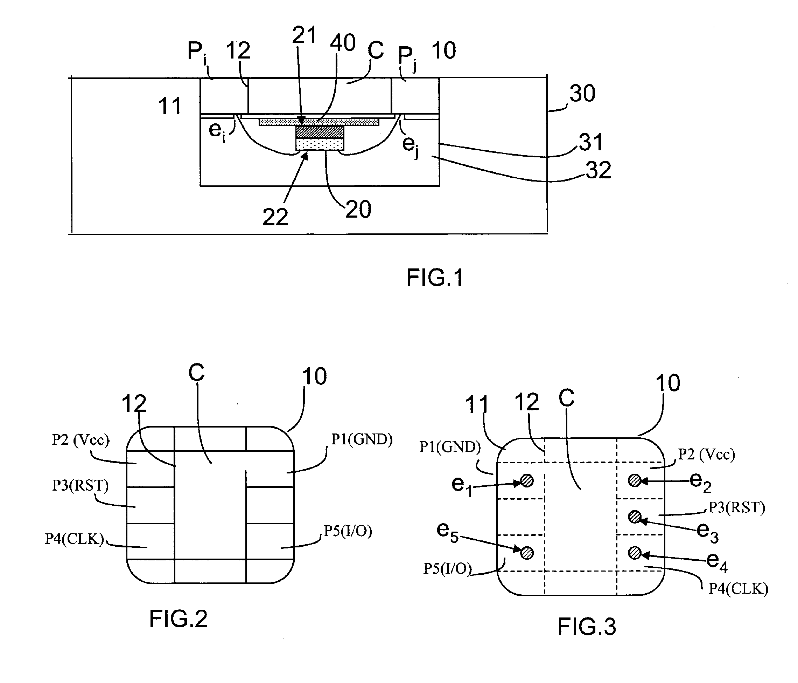

Pour mieux comprendre cette problématique d'accès à la face active, prenons l'exemple d'une carte à contacts et rappelons brièvement sa structure : une telle carte comprend (Figure 1) au moins les trois éléments matériels suivants: une vignette 10 avec des plages de contact Pᵢ, Pⱼ, pour la connexion externe (appelée encore circuit imprimé dans la littérature), au moins un microcircuit 20 connecté aux plages de contact, et un corps de carte 30 dans lequel est formé une cavité 31 pour encapsuler le module formé du microcircuit et de la vignette, avec une face du microcircuit faisant face au fond de la cavité et la vignette affleurant en surface du corps de carte. La carte peut en outre comprendre d'autres éléments (circuits, antenne, écran...) disposés sur des feuilles d'insert dans l'épaisseur du corps de carte entre le bas de la carte et le fond de la cavité (non représenté).

La vignette 10 est une pièce qui comprend un support diélectrique 11, par exemple un film époxy. Sa face recto (Figure 2) sera la face visible en surface de la carte. Cette face recto porte un motif de plages de contact métalliques réalisé sur le support diélectrique 11, qui forme le connecteur de la carte : c'est sur ces plages de contact que viendront se positionner les pointes d'un connecteur de lecteur de carte, pour établir une session de communication.

Sur la face verso de la vignette on trouve un microcircuit 20 dont les plots de connexion sont connectés aux plages de contact pour la connexion externe. Le microcircuit est une puce de circuit intégré, formée sur un substrat semi-conducteur qui forme la face arrière 21 de la puce, surmonté de couches actives. Le dessus de la puce forme la face active 22, et porte les plots de connexion de la puce. On en compte généralement au minimum cinq pour les applications des cartes à contacts, correspondant aux signaux électriques d'alimentation Gnd, et Vcc, et fonctionnels : initialisation RST, horloge CLK et entrée/sortie de données I/O. Les liaisons électriques avec les plages de contact externe sont réalisées par des fils conducteurs soudés : une extrémité est soudée sur un plot de connexion de la puce, et l'autre sur la plage de contact associée.

Dans l'exemple illustré à la figure 3, où la vignette 10 est une vignette simple face, la face verso est constituée par le film support 11. Dans ce cas, comme illustré, le microcircuit est collé sur cette face verso, dans une partie centrale de la vignette correspondant à la plage de contact centrale C. Et des ouvertures ménagées dans l'épaisseur du support 11 dégagent une petite surface de contact e₁ à e₅ (rayée sur la figure) au dos des plages de contact, permettant la connexion par soudure des fils conducteurs. Pour faciliter la compréhension, on a matérialisé les plages de contact de la face recto en représentant en pointillé les rainures 12 qui délimitent et séparent ces plages de contact.

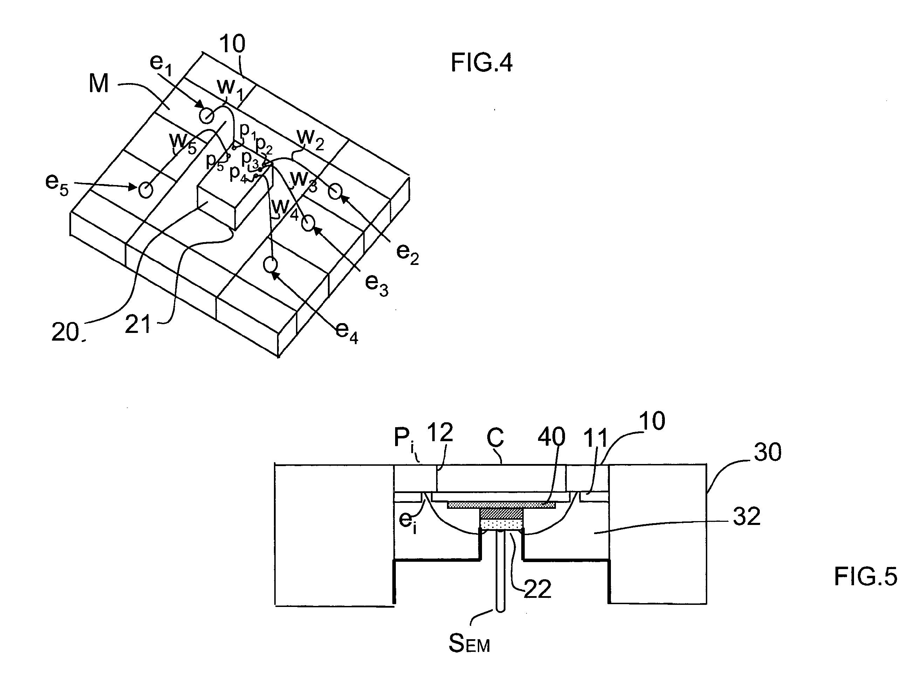

La figure 4 illustre le micromodule M après collage de la face arrière 21 du microcircuit en partie centrale C, par une couche de colle 40, et câblage par des fils conducteurs soudés w₁ à w₅ : chaque fil a une extrémité soudé sur un plot pᵢ du microcircuit (i=1 à 5), et l'autre extrémité sur la zone dégagée correspondante eᵢ au dos de la plage de contact correspondante. Pour faciliter la compréhension, on a omis de représenter le support diélectrique 11.

Le micromodule M ainsi formé, c'est-à-dire l'ensemble vignette 10, microcircuit(s) 20 et fils conducteurs w₁ à w₅ reliant des plots des microcircuits à des plages de la vignette, est ensuite placé dans une cavité 31 ménagée dans un corps de carte 30, face active 22 avec les plots de microcircuit(s) face au fond de la cavité 31, remplie de résine de protection 32, comme schématiquement illustré sur la coupe transversale de la figure 1. La résine est généralement dispensée sous forme d'une goutte par-dessus le microcircuit et ses liaisons électriques, avant l'encapsulation dans la cavité.

Ces aspects de structure et fabrication sont bien connus. Les cartes mémoire SD et les clefs USB sont différentes par leurs formes externe et la forme de leur connecteur, mais similaires en ce qui concerne le câblage par fils soudés et l'encapsulation dans un corps plastique, avec cavité et résine de protection. Et elles ont la même problématique de dégagement de face active, qui est la suivante :

Pour pouvoir approcher une sonde S_{EM} au plus près de la face active comme illustré sur la figure 5, ou appliquer un rayonnement lumineux, il faut dégager une partie de la face active du microcircuit câblé et encapsulé : il faut creuser le corps plastique d'encapsulation pour atteindre la cavité 31 et enlever sélectivement la résine 32 dans la cavité pour dégager la partie de face active voulue, cela sans altérer le câblage électrique du circuit, c'est-à-dire sans endommager, -sans casser ou arracher-, aucun des fils de connexion soudés.

Une contremesure possible est ainsi un moyen par lequel une tentative d'enlever la résine provoque nécessairement la cassure ou l'arrachement d'un fil. Cette contremesure est efficace vis-à-vis des attaques en faute ou EMA, parce que ces attaques supposent que le microcircuit soit ou reste en état de fonctionnement. Et parce que si ces attaques en faute ou EMA ne nécessite pas des moyens matériels coûteux, la réparation de ces connexions cassées ou arrachées suppose au contraire de disposer de moyens matériels sophistiqués et coûteux. Il sera donc généralement impossible de faire la réparation.

La demande de brevet FR 2857483 de la Demanderesse propose une contre-mesure de ce type. Elle propose l'utilisation de pistes conductrices formées dans le fond de la cavité, par exemple par embossage d'une feuille métallique, dans la réalisation des liaisons électriques entre un plot de connexion du microcircuit et une plage de contact externe : un plot est connecté par fil à une plage de contact, elle-même connectée par une piste conductrice à une plage de contact pour la connexion externe. Les pistes sont formées avec des parties larges et étroites. Les parties larges ont une fonction de masque optique de la face active, et les parties étroites sont là pour permettre une déconnexion électrique facile par rupture, en cas de tentative de dégagement de la face active.

Cette solution de contre-mesure intégrée implique deux étapes de procédé distinctes pour réaliser les liaisons électriques : soudure par fil et formation de pistes conductrices.

### RESUME DE L'INVENTION

L'invention propose une contre-mesure matérielle différente, qui a notamment l'avantage de ne pas nécessiter différentes étapes de réalisation des liaisons électriques.

L'idée à la base de l'invention est de réaliser au moins un des fils de connexion du microcircuit avec une portion de fil qui passe au-dessus de la face active. Ceci est réalisé de manière simple en pilotant (programmant) de manière appropriée la tête de positionnement et soudure du fil de manière correspondante.

Ainsi, au lieu d'avoir des fils qui partent tous directement d'un plot en bord de microcircuit, vers l'extérieur, sur la plage de contact correspondante, au moins un des fils fait un détour qui passe au-dessus de la face active du microcircuit, avant de partir vers l'extérieur, sur une plage de contact.

L'effet technique associé est de rendre extrêmement difficile le retrait de la résine sans casser ce fil qui passe dans le champ d'action de l'attaquant.

Ainsi, l'invention concerne un dispositif connectable portable à microcircuit(s), comportant un support de microcircuit(s) encapsulé dans un corps en matière plastique, ledit support comprenant :
- un microcircuit fixé par sa face arrière en surface du support, et dont une face active opposée à la face arrière porte des plots de connexion électrique,
- des plages de contact pour la connexion externe, disposées sur le support, en périphérie du microcircuit,
- des liaisons électriques par fils conducteurs soudés, chacune pour relier électriquement un des plots du microcircuit à une plage de contact externe.
Selon l'invention, au moins un fil conducteur soudé à une extrémité sur un plot du microcircuit, ne suit pas un chemin direct de ce plot vers l'extérieur du microcircuit jusqu'à la plage de contact à laquelle il doit être relié, mais fait un détour pour passer au-dessus de la face active avant de partir vers l'extérieur.

L'invention concerne aussi un procédé de fabrication correspondant.

D'autres caractéristiques et avantages de l'invention sont décrits ci-après dans la description d'un mode de réalisation de l'invention, et à l'aide des dessins annexés dans lesquels:
- la figure 1 est une vue en coupe transversale d'une carte à contacts;
- la figure 2 est une vue de la face recto de la vignette de cette carte;
- la figure 3 est une vue de la face verso de cette vignette;
- la figure 4 est une vue de dessus d'un micromodule, montrant le montage et la connexion d'un microcircuit au dos de la vignette;
- la figure 5 est une vue illustrant une attaque EMA par mise à découvert de la face active d'un microcircuit;
- les figures 6 à 8 illustrent différentes variantes de réalisation d'une contre-mesure selon l'invention, dans une carte à contacts;
- la figure 9 est une vue schématique d'une carte mémoire sécurisée amovible de stockage de données SD; et
- la figure 10 illustre des exemples de réalisation d'une contre-mesure selon l'invention dans une telle carte.

### DESCRIPTION DETAILLEE

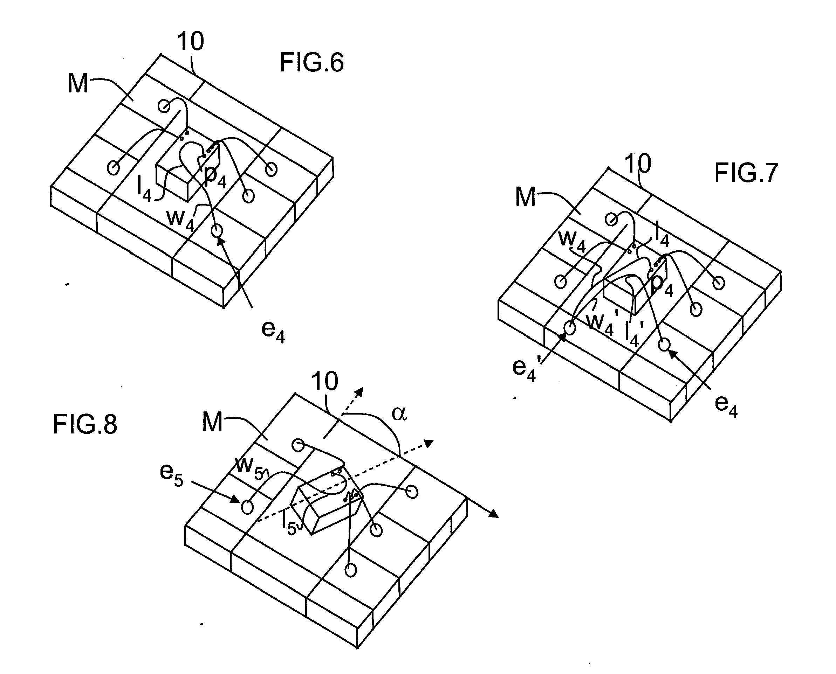

Dans l'exemple illustré sur la figure 6, le fil de connexion w₄ qui part du plot de connexion p₄ du microcircuit, ne suit pas un chemin direct depuis ce plot vers la plage de contact correspondante matérialisée par la zone e₄, mais fait un détour l₄ qui passe au-dessus de la face active du microcircuit, avant d'aller sur cette plage.

Typiquement une tête de soudure et déroulement du fil de connexion, suivra les étapes suivantes, en prenant comme convention que la tête est normalement positionnée sur un plot pour faire un déplacement vers
- positionnement sur le plot, et soudure d'une extrémité du fil;
- déroulement du fil avec un déplacement de la tête ascendant et vers l'arrière, en formant une sorte de boucle au dessus de la face active pour repartir ensuite dans la direction opposée vers la plage de contact e₄, avec un déplacement de la tête vers l'avant et progressivement descendant, jusqu'à atteindre la plage de contact, et soudure de l'autre extrémité du fil sur la plage.

En pratique le détour au-dessus de la face active peut suivre un chemin quelconque. Un seul impératif : ne pas toucher ni la face active ni aucun des autres fils de connexion.

Selon la dimension de la puce de microcircuit, on peut envisager de réaliser une telle connexion "avec détour" sur plusieurs plots, au moins deux.

On choisit de préférence d'utiliser une telle connexion par fil avec détour à un plot associé à un signal électrique externe très handicapant sur le plan opérationnel. En référence à la figure 2, le signal de masse (Vss), le signal d'horloge (CLK), le signal d'initialisation (RST) ou le signal de données (I/O) conviennent. Le signal d'alimentation logique (Vcc) n'est lui pas efficace pour la contre-mesure. On sait en effet qu'il est possible qu'un microcircuit arrive à retirer l'énergie suffisante à son fonctionnement à partir d'un signal fonctionnel (horloge, données...).

Dans une variante représentée sur la figure 7, pour augmenter l'efficacité de la contre-mesure en augmentant la surface de face active survolée, on prévoit une plage de contact intermédiaire, et deux fils de connexion, un premier reliant le plot à la plage de contact intermédiaire e₄', et un deuxième w₄' reliant cette plage à la plage de contact de connexion externe e₄. Les deux fils sont chacun formés pour passer au-dessus de la face active. En particulier, et comme illustré, la plage de contact intermédiaire e₄' peut être disposée d'un côté du microcircuit qui oblige de par sa position à faire passer le fil de connexion w₄ au-dessus de la face active. L'autre fil est formé de manière à faire un détour. Différentes possibilités de positionnement de la plage de contact intermédiaire relativement au plot et à la plage de contact externe sont envisageables dans la limite des contraintes imposées pour ne provoquer aucun court-circuit avec d'autres fils.

La figure 8 illustre une autre variante qui peut se combiner avec les réalisations vues précédemment. Dans cette variante, la position du microcircuit sur le support relativement aux plages de contact est choisie pour optimiser la surface survolée par le ou les fils de connexion. Notamment on peut déplacer latéralement le microcircuit, mais aussi le faire pivoter d'un angle donné α. Plus précisément, en considérant que les plages de contact sont alignées de part et d'autre de la zone centrale C, en rangées, et que le microcircuit a une forme généralement rectangulaire, un axe longitudinal du microcircuit forme alors un angle α avec la direction des rangées de plages de contact.

Ainsi, selon le nombre de plots de la puce, la surface de la puce, et les possibilités de positionnement du microcircuit relativement aux plages de contact, on peut réaliser une contre-mesure optimale, offrant la plus grande couverture de face active, telle que si on cherche à enlever la résine même très localement, dans une petite zone, on est pratiquement certain de casser un fil, empêchant ainsi le fonctionnement du microcircuit.

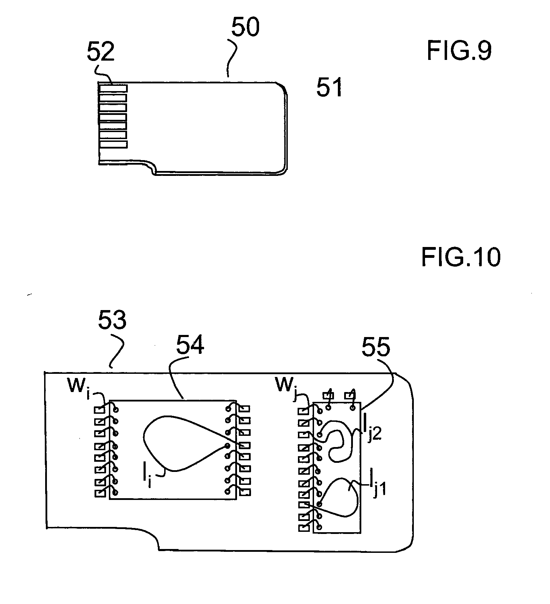

La contremesure de l'invention dont une application vient d'être plus particulièrement décrite pour une carte à contact en relation avec les figures 1 à 8, s'applique à tout dispositif portable connectable à microcircuit(s), dans lequel le câblage des microcircuits aux plages de contact pour la connexion externe est réalisé par fils soudés. L'homme du métier sait appliquer le principe de l'invention à ces différents dispositifs, en prenant en compte leurs contraintes propres de place et de surface, pour optimiser la surface de face active survolée, tout en respectant les différentes contraintes de connexion pour ne pas risquer de court-circuit entre des fils ou avec la face active. Par exemple, les figures 9 et 10 illustrent schématiquement l'application d'une contremesure selon l'invention à une carte mémoire sécurisée amovible de stockage de données, de type carte SD. La figure 9 est une vue simplifiée d'une telle carte SD 50 comprenant un corps plastique 51, portant un connecteur 52.

La figure 10 montre un support de microcircuit(s) 53 d'une telle carte. Ce support est en pratique encapsulé selon les techniques habituelles (cavité, résine de protection) dans le corps de carte 51. Dans l'exemple, il comporte deux microcircuits 54 et 55, par exemple un pour gérer l'interface et un autre de type mémoire de masse, qui sont câblés par fils de connexion soudés, wᵢ, wⱼ à des plages de contact disposées sur le support, autour des microcircuits.

Selon le principe de l'invention déjà exposé, une protection d'un microcircuit est réalisée avec au moins un fil formé avec un détour passant au-dessus de la face active. Selon la surface disponible, on peut prévoir plusieurs fils formés de cette façon. C'est ce qui est illustré pour le microcircuit 55, qui a deux fils de connexion chacun à détours Iⱼ₁ et Iⱼ₂ au dessus de la face active. Les variantes discutées en relation avec les figures 7 et 8 sont également applicables. En pratique selon les risques un seul, plusieurs, ou tous les microcircuits auront une contre-mesure selon l'invention.

L'homme du métier saura appliquer de manière similaire une contremesure selon l'invention à d'autres types de dispositifs (clefs USB, cartes à microcircuit(s) sans contact, cartes duales ....)

Quant au choix du ou des signaux auxquels appliquer la contremesure selon l'invention, ce choix dépend notamment de la nature de la communication externe : sans contact, avec contact(s), et du protocole de communication associé.

On a vu que le signal auquel appliquer la contremesure doit être handicapant, fonctionnel, permettant de couper ou gêner fortement la communication externe en cas d'absence. Ce peut être un signal de masse, un signal d'horloge ou un signal de données (communication externe avec contact), ou encore un signal radiofréquence (communication externe sans contact, par antenne). Dans ce dernier cas, le choix est simple, le microcircuit ayant deux plots connecté aux deux plots d'antenne, aux bornes desquelles un signal radiofréquence est émis/reçu : la contremesure de l'invention sera appliqué à l'un ou l'autre plot, voire les deux plots du microcircuit qui sont connectés à l'antenne.

Dans le cas d'un dispositif à communication par contact(s), il existe différents protocoles et certains dispositifs peuvent même en implémenter plusieurs. On peut notamment citer le protocole associé à la définition des signaux électrique de la norme ISO7816 des cartes à microcircuit(s) (Figure 2 & 3), le protocole USB (2 signaux d'alimentation 2 signaux de données), ou encore le protocole SWP (*"Single Wire Protocol*) par lequel le dispositif communique par contact via un seul fil, via un circuit convertisseur en champ proche, à antenne (circuit NFC) qui lui communique sans contact avec l'extérieur.

De préférence, pour ne pas dépendre du type de protocole implémenté, on appliquera de préférence la contremesure selon l'invention au signal de masse électrique. En effet, la disparition du signal de masse électrique coupe la communication par contact. C'est donc un signal efficace pour la contremesure et qui a en outre l'avantage d'être universel.

Par ailleurs, il est possible d'appliquer la contremesure à un autre ou plusieurs autres signaux à la place, ou en plus du signal de masse électrique : la contremesure sera alors plus spécifique du protocole de communication par contact(s) implémenté dans le dispositif considéré.

Enfin, dans le cas d'un dispositif mixte, implémentant à la fois un protocole type avec contact (ISO7816, USB, SWP, ...) et un protocole sans contact, tel qu'une carte à microcircuit(s) dite "carte duale", on appliquera la contremesure de l'invention de préférence à au moins deux signaux, l'un choisi pour agir comme contremesure associée à la communication avec contact(s), de préférence le signal de masse électrique, et l'autre, le signal radiofréquence, pour agir comme contremesure associée à la communication sans contact.

L'invention ne se limite pas aux seuls dispositifs et/ou protocoles indiqués à titre d'exemples dans la description, mais s'applique de façon générale à tout dispositif portable connectable à microcircuit(s), dans lequel le câblage des microcircuits aux plages de contact pour la connexion externe est réalisé par fils soudés.

## Revendications

1. Dispositif connectable portable à microcircuit(s) comportant un support de microcircuit(s) encapsulé dans un corps en matière plastique (10), ledit support comprenant :
- un microcircuit (20) fixé par sa face arrière en surface du support, et dont une face dite active (22) opposée à la face arrière porte des plots de connexion électrique,
- des plages de contact (e₁, e₂, e₃, e₄, e₅) pour la connexion externe, disposées sur le support, en périphérie du microcircuit,
- des liaisons électriques par fils conducteurs (w₁, w₂, w₃, w₄, w₅) soudés chacune pour relier électriquement un des plots du microcircuit à une plage de contact externe,
**caractérisé en ce qu'**au moins un fil conducteur (w₄) soudé à une extrémité sur un plot du microcircuit, ne suit pas un chemin direct de ce plot vers l'extérieur du microcircuit jusqu'à la plage de contact à laquelle il doit être relié, mais fait un détour (l₄) pour passer au-dessus de la face active (22) du microcircuit avant de partir vers l'extérieur.

2. Dispositif connectable selon la revendication 1, mettant en oeuvre un protocole de communication avec l'extérieur par contact(s), dans lequel un plot du microcircuit connecté par un fil conducteur formant un tel détour au-dessus de la face active, est le plot correspondant au signal de masse électrique.

3. Dispositif connectable selon la revendication 1 ou 2, mettant en oeuvre un protocole de communication avec l'extérieur sans contact, par une antenne, dans lequel un plot du microcircuit connecté par un fil conducteur formant un tel détour au-dessus de la face active, est un plot du microcircuit connecté à un plot d'antenne.

4. Dispositif connectable selon l'une quelconque des revendications 1 à 3, dans lequel un plot du microcircuit (p₄) est connecté à une plage de contact externe (e₄) par deux fils conducteurs soudés, un premier fil (w₄) soudé entre ledit plot et une plage de contact intermédiaire (e₄'), et un deuxième fil (w₄') entre la plage de contact de transition et la plage de contact externe, et en ce que chacun des deux fils (l₄, l₄') passe au-dessus de la face active du microcircuit.

5. Dispositif connectable selon la revendication 4, dans lequel ladite plage de contact intermédiaire est positionnée sur le support, en sorte que le fil de connexion entre le plot associé et cette plage passe nécessairement au dessus de la face active.

6. Dispositif connectable selon l'une des revendications 1 à 5, dans lequel la position du microcircuit par rapport aux plages de contact est choisie pour optimiser la surface survolée par le ou les fils passant au-dessus de la face active.

7. Dispositif connectable selon la revendication 6, dans lequel un axe longitudinal du microcircuit fait un angle non nul (α) avec une direction d'alignement des plages.

8. Dispositif connectable selon l'une quelconque des revendications précédentes, correspondant à l'un des dispositifs suivant: carte à contact(s) et/ou sans contacts, clef USB, carte mémoire sécurisée amovible de stockage de données.

9. Procédé de fabrication d'un dispositif connectable portable à microcircuit(s) comportant un support de microcircuit(s) encapsulé, ledit support comprenant :
- une étape de réalisation sur le support de plages de contact pour la connexion externe, autour d'une zone (C) de fixation d'un microcircuit,
- une étape de fixation d'un microcircuit sur ladite zone, par la face opposée (21) à la face dite active (22) qui porte des plots de connexion électrique en bordure,
- une étape de fixation par soudure de fils conducteurs (w₁, w₂, w₃, w₄, w₅) pour relier électriquement chaque plot du microcircuit à une plage de contact externe correspondante (e₁, e₂, e₃, e₄, e₅),
**caractérisé en ce que** dans ladite étape de fixation, au moins un fil conducteur (w₄) soudé à une extrémité sur un plot du microcircuit, ne suit pas un chemin direct de ce plot vers l'extérieur du microcircuit jusqu'à la plage de contact à laquelle il doit être relié, mais fait un détour (l₄) pour passer au-dessus de la face active (22) du microcircuit avant de partir vers l'extérieur.

10. Procédé de fabrication selon la revendication 9, **caractérisé en ce qu'**il comprend la formation d'au moins une plage de contact intermédiaire sur le support autour de ladite zone de fixation du microcircuit, et la connexion d'un plot du microcircuit (p₄) à une plage de contact externe (e₄) par deux fils conducteurs soudés, un premier fil (w₄) soudé entre ledit plot et une plage de contact intermédiaire (e₄'), et un deuxième fil (w₄') entre cette plage de contact intermédiaire et la plage de contact externe, et **en ce que** chacun des deux fils (l₄, l₄') passent au-dessus de la face active du microcircuit.

11. Procédé de fabrication selon la revendication 9 ou la revendication 10, **caractérisé en ce que** le microcircuit est placé relativement aux plages de contact dans une position qui optimise la surface survolée par le ou les fils passant au-dessus de la face active.

12. Procédé selon la revendication 10, dans lequel la plage de contact intermédiaire est positionnée sur le support, en sorte que le fil de connexion entre le plot associé et cette plage passe nécessairement au dessus de la face active.

13. Procédé selon la revendication 11, dans lequel cette position est telle qu'un axe longitudinal du microcircuit fait un angle non nul (α) avec une direction d'alignement des plages.

## Patentansprüche

1. Tragbare, anschließbare Vorrichtung mit (einer) Mikroschaltung(en), die einen Mikroschaltungsträger umfasst, der in einem Plastikkörper (10) verkapselt ist, wobei der Träger Folgendes umfasst:
- eine Mikroschaltung (20), die mit ihrer Rückseite an der Oberfläche des Trägers befestigt ist und von der eine Fläche (22), aktive Fläche genannt, elektrische Anschlusspole gegenüber der hinteren Fläche hat;
- Kontaktinseln (e₁, e₂, e₃, e₄, e₅) für den externen Anschluss, die an der Peripherie der Mikroschaltung an dem Träger angeordnet sind;
- elektrische Verbindungen durch leitende Drähte (w₁, w₂, w₃, w₄, w₅), die jeweils so verlötet sind, dass einer der Pole der Mikroschaltung elektrisch mit einer externen Kontaktinsel verbunden wird,
**dadurch gekennzeichnet, dass** wenigstens ein an ein Ende eines Pols der Mikroschaltung gelöteter leitender Draht (w₄) keinem direkten Pfad von diesem Pol zur Außenseite der Mikroschaltung bis zu der Kontaktinsel folgt, mit der er verbunden werden soll, sondern einen Umweg (l₄) über die aktive Fläche (22) der Mikroschaltung macht, bevor er nach außen geht.

2. Anschließbare Vorrichtung nach Anspruch 1, die ein Kommunikationsprotokoll mit der Außenseite über (einen) Kontakt(e) impementiert, wobei ein Pol der Mikroschaltung, die über einen leitenden Draht verbunden ist, der einen solchen Umweg über die aktive Fläche macht, der Pol ist, der dem elektrischen Massesignal entspricht.

3. Anschließbare Vorrichtung nach Anspruch 1 oder 2, die ein Kommunikationsprotokoll mit der Außenseite über eine Antenne kontaktlos implementiert, wobei ein Pol der Mikroschaltung, die über einen leitenden Draht angeschlossen ist, der einen solchen Umweg über die aktive Fläche macht, ein Pol der an einen Pol der Antenne angeschlossen Mikroschaltung ist.

4. Anschließbare Vorrichtung nach einem der Ansprüche 1 bis 3, wobei ein Pol der Mikroschaltung (p₄) über zwei gelötete leitende Drähte an eine externe Kontaktinsel (e₄) angeschlossen ist, wobei ein erster Draht (w₄) zwischen dem Pol und einer Zwischenkontaktinsel (e₄') und ein zweiter Draht (w₄') zwischen der Übergangskontaktinsel und der externen Kontaktinsel gelötet ist, und dadurch, dass jeder der zwei Drähte (l₄, l₄') über die aktive Fläche der Mikroschaltung geht.

5. Anschließbare Vorrichtung nach Anspruch 4, wobei die Zwischenkontaktinsel so auf dem Träger positioniert ist, dass der Anschlussdraht zwischen dem assoziierten Pol und dieser Insel unbedingt über die aktive Fläche geht.

6. Anschließbare Vorrichtung nach einem der Ansprüche 1 bis 5, wobei die Position der Mikroschaltung relativ zu den Kontaktinseln so gewählt wird, dass die Oberfläche, über die die ein oder mehreren über die aktive Fläche verlaufenden Drähte verlaufen, optimiert wird.

7. Anschließbare Vorrichtung nach Anspruch 6, wobei eine Längsachse der Mikroschaltung einen Winkel (α) von ungleich null mit einer Verlaufsrichtung der Inseln bildet.

8. Anschließbare Vorrichtung nach einem der vorherigen Ansprüche, entsprechend einer der folgenden Vorrichtungen: eine Platine mit oder ohne Kontakt(e), ein USB-Schlüssel, eine sichere entfernbare Datenspeicherkarte.

9. Verfahren zur Herstellung einer tragbaren anschließbaren Vorrichtung mit (einer) Mikroschaltung(en), die einen verkapselten Mikroschaltungsträger umfasst, wobei der Träger Folgendes umfasst:
- einen Schritt des Erzeugens von Kontaktinseln auf dem Träger für den externen Anschluss um eine Zone (C) zum Befestigen einer Mikroschaltung;
- einen Schritt des Befestigens einer Mikroschaltung an der Zone über die Fläche (21) gegenüber der aktiven Fläche (22), die elektrische Anschlusspole an der Peripherie trägt;
- einen Schritt des Lötbefestigens von leitenden Drähten (w₁, w₂, w₃, w₄, w₅), um jeden Pol der Mikroschaltung elektrisch an eine entsprechende externe Kontaktinsel (e₁, e₂, e₃, e₄, e₅) anzuschließen,
**dadurch gekennzeichnet, dass** bei dem Befestigungsschritt wenigstens ein leitender Draht (w₄), der an ein Ende an einem Pol der Mikroschaltung gelötet ist, keinem direkten Pfad von diesem Pol zur Außenseite der Mikroschaltung bis zur Kontaktinsel folgt, an die er angeschlossen werden soll, sondern einen Umweg (l₄) über die aktive Fläche (22) der Mikroschaltung macht, bevor er nach außen geht.

10. Herstellungsverfahren nach Anspruch 9, **dadurch gekennzeichnet, dass** es die Bildung von wenigstens einer Zwischenkontaktinsel auf dem Träger um die Zone zum Befestigen der Mikroschaltung beinhaltet und der Anschluss eines Pols der Mikroschaltung (p₄) an eine externe Kontaktinsel (e₄) über zwei gelötete leitende Drähte beinhaltet, einem ersten zwischen dem Pol und einer Zwischenkontaktinsel (e₄') gelöteten Draht (w₄) und einem zweiten zwischen dieser Zwischenkontaktinsel und der externen Kontaktinsel gelöteten Draht (w₄'), und dadurch, dass jeder der zwei Drähte (l₄, l₄') über die aktive Fläche der Mikroschaltung verläuft.

11. Herstellungsverfahren nach Anspruch 9 oder Anspruch 10, **dadurch gekennzeichnet, dass** sich die Mikroschaltung relativ zu den Kontaktinseln in einer Position befindet, die die Oberfläche optimiert, über die die ein oder mehreren Drähte über die aktive Fläche verlaufen.

12. Verfahren nach Anspruch 10, wobei die Zwischenkontaktinsel so auf dem Träger positioniert ist, dass der Anschlussdraht zwischen dem assoziierten Pol und dieser Insel unbedingt über die aktive Fläche verläuft.

13. Verfahren nach Anspruch 11, wobei diese Position derart ist, dass eine Längsachse der Mikroschaltung einen Winkel (α) von ungleich null mit einer Verlaufsrichtung der Inseln bildet.

## Claims

1. A portable connectable device with microcircuit(s), comprising a microcircuit support encapsulated in a plastic body (10), said support comprising:
- a microcircuit (20) fixed by its rear face to the surface of said support, and a face (22), referred to as active face, of which opposite said rear face has electrical connection pins;
- contact pads (e₁, e₂, e₃, e₄, e₅) for the external connection, disposed on said support on the periphery of said microcircuit;
- electrical connections via conducting wires (w₁, w₂, w₃, w₄, w₅) each soldered in order to electrically connect one of the pins of said microcircuit to an external contact pad,
**characterised in that** at least one conducting wire (w₄) soldered to one end on a pin of said microcircuit does not follow a direct path from said pin to the outside of said microcircuit up to the contact pad to which it is to be connected, but makes a detour (l₄) in order to pass over said active face (22) of said microcircuit before going outside.

2. The connectable device according to claim 1, implementing a communication protocol with the outside by means of (a) contact(s), wherein a pin of said microcircuit connected via a conducting wire forming such a detour over said active face is the pin that corresponds to the electrical ground signal.

3. The connectable device according to claim 1 or 2, contactless implementing a communication protocol with the outside, via an antenna, wherein a pin of said microcircuit connected via a conducting wire forming such a detour over said active face is a pin of said microcircuit connected to a pin of said antenna.

4. The connectable device according to any one of claims 1 to 3, wherein a pin of said microcircuit (p₄) is connected to an external contact pad (e₄) via two soldered conducting wires, a first wire (w₄) soldered between said pin and an intermediate contact pad (e₄') and a second wire (w₄') between the transition contact pad and the external contact pad, and in that each of said two wires (l₄, l₄') passes over said active face of said microcircuit.

5. The connectable device according to claim 4, wherein said intermediate contact pad is located on said support so that the connection wire between the associated pin and said pad has to pass over said active face.

6. The connectable device according to any one of claims 1 to 5, wherein the position of said microcircuit relative to the contact pads is selected so as to optimise the surface passed over by the one or more wires passing over said active face.

7. The connectable device according to claim 6, wherein a longitudinal axis of said microcircuit forms a non-zero angle (α) with a direction of alignment of said pads.

8. The connectable device according to any one of the preceding claims, corresponding to one of the following devices: a board with or without contacts, a USB key, a secure removable data storage memory card.

9. A method for manufacturing a portable connectable device with microcircuit(s) comprising an encapsulated microcircuit(s) support, said support comprising:
- a step of producing contact pads on said support for the external connection around a zone (C) for fixing a microcircuit;
- a step of fixing a microcircuit to said zone via the face (21) opposite said active face (22) with electrical connection pins on its periphery;
- a step of soldering conducting wires (w₁, w₂, w₃, w₄, w₅) in order to electrically connect each pin of said microcircuit to a corresponding external contact pad (e₁, e₂, e₃, e₄, e₅),
**characterised in that** in said fixing step at least one conducting wire (w₄) soldered to one end on a pin of said microcircuit does not follow a direct path from said pin to the outside of said microcircuit up to the contact pad to which it is to be connected, but makes a detour (l₄) in order to pass over said active face (22) of said microcircuit before going outside.

10. The manufacturing method according to claim 9, **characterised in that** it comprises the formation of at least one intermediate contact pad on said support around said zone for fixing said microcircuit, and the connection of a pin of said microcircuit (p₄) to an external contact pad (e₄) via two soldered conducting wires, a first wire (w₄) soldered between said pin and an intermediate contact pad (e₄') and a second wire (w₄') between said intermediate contact pad and the external contact pad, and **in that** each of said two wires (l₄, l_{4'}) passes over said active face of said microcircuit.

11. The manufacturing method according to claim 9 or 10, **characterised in that** said microcircuit is positioned relative to the contact pads in a position that optimises the surface passed over by the one or more wires passing over said active face.

12. The method according to claim 10, wherein said intermediate contact pad is located on said support so that the connection wire between the associated pin and said pad has to pass over said active face.

13. The method according to claim 11, wherein this position is such that a longitudinal axis of said microcircuit forms a non-zero angle (α) with a direction of alignment of said pads.
